# EUROPÄISCHE PATENTSCHRIFT

(11) **EP 2 079 116 B1**
(45) Veröffentlichungstag und Bekanntmachung des Hinweises auf die Patenterteilung: **12.08.2015**
(21) Anmeldenummer: 09100015.8
(22) Anmeldetag: 07.01.2009
(51) Int. Cl.: H01L 41/053, F02M 51/06, H01L 41/083, F02M 63/00

(54) **Piezoelektrisches Aktormodul**
Piezo-electric actuator module
Module d'actionneur piézoélectrique

(30) Priorität: 14.01.2008 DE 102008004247
(43) Veröffentlichungstag der Anmeldung: 15.07.2009
(73) Patentinhaber: ROBERT BOSCH GMBH, 70442 Stuttgart (DE)
(72) Erfinder: Mattes, Patrick, 70569, Stuttgart (DE); Zeh, Dietmar, 71732, Tamm (DE); Schlegl, Nicole, 73635, Rudersberg (DE)

(56) Entgegenhaltungen:
- WO-A2-02/50191
- WO-A2-2007/093921

## Beschreibung

### Stand der Technik

Die Erfindung betrifft ein piezoelektrisches Aktormodul für ein Brennstoffeinspritzventil und ein Brennstoffeinspritzventil mit solch einem piezoelektrischen Aktormodul. Speziell betrifft die Erfindung das Gebiet der Injektor für Brennstoffeinspritzanlagen von luftverdichtenden, selbstzündenden Brennkraftmaschinen.

Aus der DE 102 17 361 A1 ist ein piezoelektrisches Element und eine mit diesem piezoelektrischem Element versehene Einspritzdüse bekannt. Das bekannte piezoelektrische Element umfasst eine Keramikaufschichtung, die abwechselnd übereinander gestapelt mehrere Keramikschichten aus piezoelektrischer Keramik und mehrere Innenelektrodenschichten enthält. Auf einem Teil der Oberfläche der Keramikaufschichtung ist eine organische Isolationsschicht aus organischem Material ausgebildet. Ferner ist auf der organischen Isolationsschicht eine anorganische Isolationsschicht aus anorganischem Material ausgebildet. Dabei hat die organische Isolationsschicht genügend Elastizität, um die Auslenkung des piezoelektrischen Elements zu absorbieren.

Das aus der DE 102 17 361 A1 bekannte piezoelektrische Element und die mit diesem piezoelektrischen Element versehene Einspritzdüse haben den Nachteil, dass die Ausgestaltung relativ aufwändig ist. Ferner besteht das Problem, dass bei der Herstellung oder im Betrieb auftretende Öffnungen oder Risse in der anorganischen Isolationsschicht ein Eindringen von Brennstoff in die organische Isolationsschicht ermöglichen, wodurch es zu Kurzschlüssen zwischen den Innenelektrodenschichten kommt.

Ein weiteres Aktormodul ist aus WO 2007 / 093921 A2 bekannt. Ein herkömmliches Sol-Gel Verfahren ist aus WO 02 / 50191 A2 bekannt.

### Offenbarung der Erfindung

Das erfindungsgemäße piezoelektrische Aktormodul mit den Merkmalen des Anspruchs 1 und das erfindungsgemäße Brennstoffeinspritzventil mit den Merkmalen des Anspruchs 6 haben den Vorteil, dass eine relativ kostengünstige Herstellung ermöglicht ist, wobei ein zuverlässiger Schutz gegenüber Medien gewährleistet ist, und dass insbesondere eine hohe Zuverlässigkeit und Funktionsfähigkeit gewährleistet ist.

Durch die in den Unteransprüchen aufgeführten Maßnahmen sind vorteilhafte Weiterbildungen des im Anspruch 1 angegebenen piezoelektrischen Aktormoduls und des im Anspruch 6 angegebenen Brennstoffeinspritzventils möglich.

In vorteilhafter Weise ist die Beschichtung, die den Aktorkörper umgibt, durch eine Sol-Gel-Transformation ausgebildet. Die Herstellung der Beschichtung kann dabei durch ein Sol-Gel-Verfahren erfolgen, dessen Besonderheit darin besteht, dass die Herstellung oder Abscheidung der Werkstoffe jeweils von einem flüssigen Sol-Zustand ausgeht, der durch die Sol-Gel-Transfortmation in einen festen Gel-Zustand überführt wird.

Als Sole werden Dispersionen fester Partikel bezeichnet, wobei die Partikelgröße in vorteilhafter Weise im Bereich von etwa 1 nm bis etwas 100 nm liegen kann. Die Partikel befinden sich dabei vorzugsweise feinst verteilt, das heißt dispergiert, in Wasser oder organischen Lösungsmitteln. Ein Sol-Gel-Verfahren kann in vorteilhafter Weise von Solsystemen auf der Basis metallorganischer Polymere ausgehen. Der Übergang vom flüssigen Sol zum keramischen Werkstoff erfolgt jeweils über einen Gelzustand. Während der Sol-Gel-Transformation erfolgt vorzugsweise eine dreidimensionale Vernetzung der Nanopartikel im Lösungsmittel, wodurch das Gel Festkörpereigenschaften erhält. Die Überführung des Gels in einen oxidkeramischen Werkstoff oder dergleichen erfolgt in vorteilhafter Weise durch eine kontrollierte Wärmebehandlung unter Luft.

Der zunächst flüssige Sol-Film kann in kostengünstiger Weise auf eine Außenfläche des Aktorkörpers 23 aufgebracht werden, wobei Unebenheiten, insbesondere Kanten und Vertiefungen, aufgefüllt und durch den Sol-Film ausgeglichen werden. Der zunächst flüssige Sol-Film transformiert sich dann nach kurzer Trocknung in einen festen Gel-Film. Dieser Gel-Film kann einer Wärmebehandlung unter einer sauerstoffhaltigen Atmosphäre, insbesondere Luft, unterzogen werden. Beispielsweise kann sich bei einer Wärmebehandlung bis ca. 400° C eine Zersetzung der organischen Bestandteile der metallorganischen Polymere erreicht werden, wobei die organischen Bestandteile in Form von Kohlendioxid und Wasser entweichen. Der zurückbleibende amorphe und nanoporöse Metalloxid-Film kann beispielsweise bei Temperaturen über 500° C gesintert werden. Gleichzeitig findet während der Wärmebehandlung eine Keimbildung und ein Kristallwachstum statt, so dass aus dem amorphen und porösen Gel-Film ein kristalliner, insbesondere nanokristalliner, dichter, oxidkeramischer Film entsteht.

Bei einem Sol-Gel-Verfahren handelt es sich allgemein um ein nasschemisches Verfahren zur Herstellung keramischer oder keramisch-organischer Werkstoffe. Ein solches allgemeines Sol-Gel-Verfahren kann zur Herstellung keramischer Bulkmaterialien, keramischer Nanopulver und Fasern sowie zur Abscheidung homogener nanokristalliner oxidkeramischer oder auch keramisch-organischer Beschichtungen eingesetzt werden. Im Rahmen der Erfindung wird das Sol-Gel-Verfahren zur Ausbildung der Beschichtung, die den Aktorkörper umgibt, eingesetzt. Dabei wird die Beschichtung durch eine Sol-Gel-Transformation ausgebildet.

Ein Vorteil der Ausgestaltung der Beschichtung durch eine Sol-Gel-Transformation besteht darin, dass gegebenenfalls ein aus mehreren Schichten bestehendes Beschichtungssystem vollständig durch eine Beschichtung, die im Sol-Gel-Verfahren erzeugt ist, ersetzt werden kann, so dass eine kostengünstige Herstellung ermöglicht ist. Ferner können die Eigenschaften der Beschichtung im Hinblick auf eine Druck- und Medienbeständigkeit geeignet eingestellt werden. Beispielsweise kann eine druck- und brennstoffbeständige Beschichtung, die den Aktorkörper abdichtet, erzeugt werden.

In vorteilhafter Weise ist die Beschichtung auf der Basis metallorganischer Polymere, die durch die Sol-Gel-Transformation vernetzt sind, ausgebildet. Ferner ist es vorteilhaft, dass die Beschichtung auf der Basis der in einem Lösungsmittel als Nanopartikel gelösten metallorganischen Polymere, wobei die Nanopartikel durch die Sol-Gel-Transfortmation dreidimensional in dem Lösungsmittel vernetzt sind, ausgebildet ist. Dabei ist es vorteilhaft, dass die Nanopartikel in dem Lösungsmittel eine Größe aus einem Bereich von etwa 1 nm bis etwas 100 nm aufweisen. Dadurch kann eine druck- und medienbeständige Beschichtung erzielt werden, die zudem relativ dünn ausgestaltet sein kann.

In vorteilhafter Weise ist eine außenliegende Elektrodenanbindung vorgesehen, die von der Beschichtung mitumgeben ist. Dabei kann bei der Herstellung der Beschichtung der im Sol-Zustand vorliegende Werkstoff nach der Anwendung des Sol-Gel-Verfahrens einem Wärmebehandlungsverfahren unterworfen werden, um durch Pyrolyse, Sinterung und Kristallisation eine Beschichtung in Form eines oxidkeramischen, dünnen Films auszubilden. Dabei ist die außenliegende Elektrodenanbindung vorzugsweise als wärmebeständige Elektrodenanbindung ausgeführt, um eine hinreichende Temperaturbeständigkeit, insbesondere während der Sinterung, zu gewährleisten.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
- Fig. 1: ein Brennstoffeinspritzventil mit einem piezoelektrischen Aktormodul in einer schematischen Schnittdarstellung entsprechend einem Ausführungsbeispiel der Erfindung;
- Fig. 2: einen Schnitt entlang der in Fig. 1 mit II bezeichneten Schnittlinie durch ein piezoelektrisches Aktormodul entsprechend dem Ausführungsbeispiel der Erfindung und
- Fig. 3: ein Prozessdiagramm zur Erläutung der Herstellung des piezoelektrischen Aktormoduls des Brennstoffeinspritzventils des Ausführungsbeispiels der Erfindung.

### Ausführungsformen der Erfindung

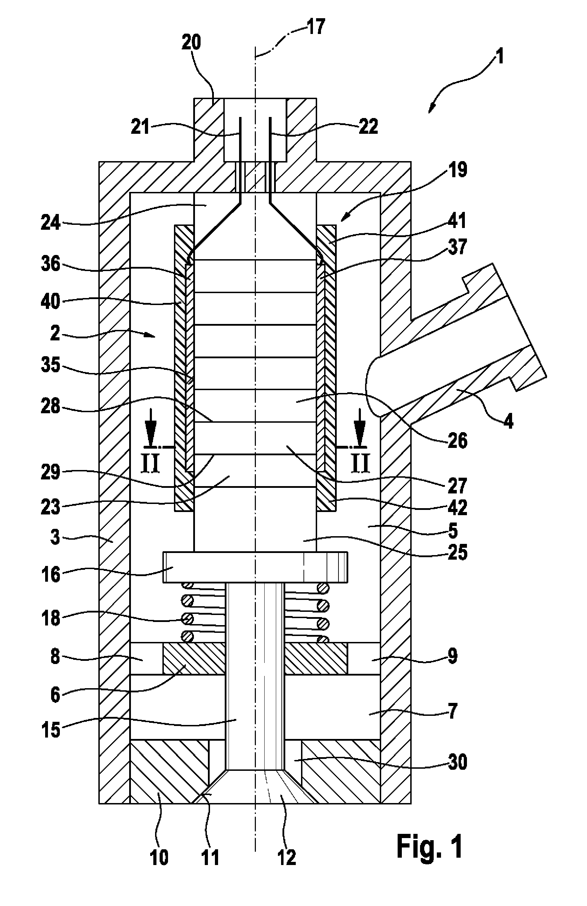

Fig. 1 zeigt ein Brennstoffeinspritzventil 1 mit einem piezoelektrischen Aktor 2 entsprechend einem ersten Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1 und auch für eine inverse Ansteuerung des piezoelektrischen Aktors 2. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch der piezoelektrische Aktor 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktors 2 angefügten Aktorfuß 24 an den Aktorkörper 23 geführt. An den Aktorkörper 23 des piezoelektrischen Aktors 2 ist ferner ein Aktorkopf 25 angefügt, über den der Aktorkörper 23 entgegen der Kraft des Federelements 18 auf die Druckplatte 16 einwirkt. Der piezoelektrische Aktor 2 weist in dem dargestellten Ausführungsbeispiel den Aktorkörper 23, den Aktorfuß 24 und den Aktorkopf 25 auf, so dass ein Aktormodul 19 gebildet ist.

Das Aktormodul 19 kann auch aus zwei oder mehr Aktorkörpern 23 aufgebaut sein. Dabei können zwischen den einzelnen Aktorkörpern 23 Zwischenstücke vorgesehen sein oder die einzelnen Aktorkörper 23 können auch an ihren Stirnflächen miteinander verklebt werden.

Der Aktorkörper 23 des piezoelektrischen Aktors 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung die keramischen Schichten 26, 27 sowie die Elektrodenschichten 28, 29 gekennzeichnet. An einer Außenfläche 35 des Aktorkörpers 23 sind außenliegende Elektrodenanbindungen 36, 37 vorgesehen, die mit den elektrischen Leitungen 21, 22 verbunden sind. Die außenliegenden Elektrodenanbindungen 36, 37 sind abwechselnd mit den Elektrodenschichten 28, 29 verbunden, so dass alterierend positive und negative Elektroden zwischen den keramischen Schichten 26, 27 vorgesehen sind.

Anstelle der außenliegenden Elektrodenanbindungen 36, 37 können auch innenliegende Elektrodenanbindungen vorgesehen sein, die im Inneren des Aktorkörpers 23 mit den Elektrodenschichten 28, 29 kontaktiert sind. Ferner ist es auch möglich, dass eine innenliegende Elektrodenanbindung mit einer außenliegenden Elektrodenanbindung 36, 37 kombiniert ist.

Über die elektrischen Leitungen 21, 22 kann der piezoelektrische Aktor 2 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des piezoelektrischen Aktors 2 zieht sich dieser wieder zusammen, so dass der zwischen dem Ventilschließkörper 12 und der Ventilsitzfläche 11 ausgebildete Dichtsitz wieder geschlossen ist.

Der Aktorkörper 23 ist an seiner Außenfläche 35 mit einer Beschichtung 40 umgeben. Ein Teil 41 der Beschichtung 40 erstreckt sich dabei auch auf den Aktorfuß 24 und ein anderer Teil 42 der Beschichtung 40 erstreckt sich auch auf den Aktorkopf 25. Die Beschichtung ist dabei durch eine Sol-Gel-Transformation ausgebildet. Dabei überdeckt die Beschichtung 40 auch die außenliegenden Elektrodenanbindungen 36, 37, die auf der Außenfläche 35 des Aktorkörpers 23 vorgesehen sind. Je nach Ausgestaltung der außenliegenden Elektrodenanbindungen 36, 37 kann die Beschichtung 40 die außenliegenden Elektrodenanbindungen 36, 37 auch nur teilweise bedecken, beispielsweise wenn die außenliegenden Elektrodenanbindungen 36, 37 aus der Beschichtung 40 herausgeführt sind.

Die Beschichtung 40 ist als nanokristalliner, dichter oxidkeramischer Film ausgebildet, so dass eine druck- und brennstoffresistente Beschichtung gegeben ist. Die Beschichtung 40 bildet somit in Bezug auf den im Aktorraum 5 vorgesehenen, unter hohem Druck stehenden Brennstoff eine zuverlässige Abdichtung gegenüber dem Aktorkörper 23 und gegebenenfalls weiterer Elemente des piezoelektrischen Aktors 2. Insbesondere wird ein Kontakt mit dem Brennstoff oder seinen Bestandteilen verhindert. Im Falle eines Dieselbrennstoffes besteht beispielsweise die Gefahr, dass im Dieselbrennstoff enthaltenes Wasser an den Aktorkörper 23 dringt und einen Kurzschluss zwischen den Elektrodenschichten 28, 29 hervorruft, wodurch es zum Ausfall des piezoelektrischen Aktors 2 kommen kann.

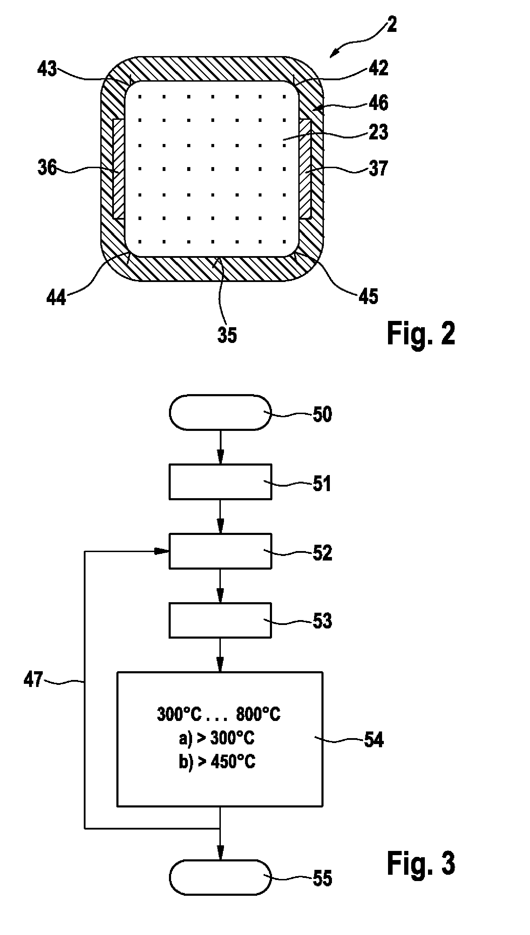

Fig. 2 zeigt einen Schnitt durch den in Fig. 1 gezeigten piezoelektrischen Aktor 2 des Aktormoduls 19 des Brennstoffeinspritzventils 1 entlang der mit II bezeichneten Schnittlinie. Die außenliegenden Elektrodenanbindungen 36, 37 sind vereinfacht dargestellt und können beispielsweise eine gewebte Struktur aufweisen. Der Aktorkörper 23 weist abgerundete Kanten 42, 43, 44, 45 auf. Somit sind spitze oder scharfkantige Kanten vermieden. Dies erleichtert die Aufbringung des Werkstoffes für die Beschichtung 40 im flüssigen Sol-Zustand. Allerdings sind im Bereich der außenliegenden Elektrodenanbindungen 36, 37, beispielsweise in einem Bereich 46, Kanten und ein Übergang von der Außenfläche 35 des Aktorkörpers 23 auf die Struktur der außenliegenden Elektrodenanbindung 37 gegeben. Der Werkstoff für die Beschichtung 40 im flüssigen Sol-Zustand passt sich an die Gegebenheiten im Bereich 46 an, so dass Hohlräume oder dergleichen aufgefüllt werden, so dass in der fertigen Beschichtung 40 Hohlräume verhindert oder zumindest verringert sind.

Die Herstellung der Beschichtung 40 ist im Folgenden anhand der Fig. 3 im Detail weiter beschrieben.

Fig. 3 zeigt ein Prozessdiagramm zur Erläuterung der Herstellung des piezoelektrischen Aktors 2 des piezoelektrischen Aktormoduls 19. Dabei ist speziell die Herstellung der Beschichtung 40, die den Aktorkörper 23 umgibt, erläutert. Das Prozessdiagramm erläutert die Herstellung in Bezug auf die Schritte 50 bis 55, denen folgende Schlagworte zugeordnet sind:
50: "Beginn des Prozesses";
51: "Solherstellung";
52: "Tauchbeschichten";
53: "Trocknung: Gelfilmbildung";
54: "Wärmebehandlung unter Luft bei etwa 300° C bis etwa 800° C";
54a: "Über 300° C: Pyrolyse";
54b: "Über 450° C: Sinterung und Kristallisation" und
55: "Ende des Prozesses: dünner Keramikfilm".

Der Prozess beginnt im Schritt 50. Dabei liegt der noch unbeschichtete Aktorkörper 23 vor, auf den gegebenenfalls die außenliegenden Elektrodenanbindungen 36, 37 angebracht sind.

Im Schritt 51 liegt ein Werkstoff im flüssigen Sol-Zustand vor, wobei es sich bei dem Sol um eine Dispersion fester Partikel im Größenbereich von etwa 1 nm bis 100 nm handelt, die sich feinst verteilt, das heißt dispergiert, in Wasser oder organischen Lösungsmitteln befinden.

Im Schritt 52 wird der Werkstoff im flüssigen Sol-Zustand auf der Außenfläche 35 des Aktorkörpers 23 abgeschieden. Die Abscheidung kann sich dabei auch auf den Aktorkörper 23 und den Aktorfuß 24 erstrecken, die an den Aktorkörper 23 angefügt sind. Die Abscheidung erfolgt durch Tauchbeschichten, wobei der Aktorkörper 23 zumindest abschnittsweise in das flüssige Sol eingetaucht und gegebenenfalls bewegt, insbesondere rotiert, wird. Die Abscheidung im Schritt 52 kann allerdings auch auf andere Weise erfolgen.

Auf den Schritt 52 folgt der Schritt 53, in dem das flüssige Sol getrocknet wird. Dabei erfolgt eine Sol-Gel-Transformation, in der der abgeschiedene Werkstoff von einem flüssigen Sol-Zustand in einen festen Gel-Zustand überführt wird. Während der Sol-Gel-Transformation kommt es zu einer dreidimensionalen Vernetzung der Nanopartikel im Lösungsmittel, wodurch das Gel Festkörpereigenschaften erhält. Die in diesem Zustand vorliegende Beschichtung 40 ist dabei an die Geometrie und Kontur des Aktorkörpers 23 sowie die außenliegenden Elektrodenanbindungen 36, 37 angepasst.

In dem auf den Schritt 53 folgenden Schritt 54 erfolgt eine Überführung des Gels der Beschichtung 40 in einen oxidkeramischen Werkstoff durch kontrollierte Wärmebehandlung unter Luft. Die Wärmebehandlung kann auch unter einer anderen sauerstoffhaltigen Atmosphäre erfolgen. In diesem Ausführungsbeispiel ist der Schritt 54 in zwei Teilschritte 54a, 54b aufgeteilt. In dem ersten Teilschritt 54a wird eine Pyrolyse durchgeführt. Dabei zersetzen sich die organischen Bestandteile der metallorganischen Polymere bis ca. 400° C und entweichen in Form von Kohlendioxid und Wasser. Der zurückbleibende amorphe und nanoporöse Metalloxidfilm wird im Schritt 54b bei Temperaturen von über 500° C gesintert. Gleichzeitig finden im Schritt 54b Keimbildung und Kristallwachstum statt, so dass aus dem amorphen und porösen Gelfilm ein kristalliner, insbesondere nanokristalliner, dichter, oxidkeramischer Film entsteht.

Nach dem Schritt 54 kann das Verfahren mit dem Schritt 55 beendet werden, wobei die Beschichtung 40 in Form eines dünnen keramischen Film vorliegt. Je nach Anwendungsfall können die Schritte 52, 53 und 54 auch ein oder mehrmals wiederholt werden, wie es durch den Sprungpfeil 47 veranschaulicht ist. In diesem Fall folgt auf den Schritt 54 der Schritt 52, in dem eine weitere Tauchbeschichtung des bereits teilbeschichteten Aktorkörpers 23 erfolgt. Somit kann die Dicke der Beschichtung 40 gezielt beeinflusst werden.

Die Erfindung ist nicht auf die beschriebenen Ausführungsbeispiele beschränkt.

## Patentansprüche

1. Piezoelektrisches Aktormodul (19), insbesondere Aktormodul für Brennstoffeinspritzventile, mit zumindest einem Aktorkörper (23), der eine Vielzahl von keramischen Schichten (26, 27) und eine Vielzahl von zwischen den keramischen Schichten (26, 27) angeordneten Elektrodenschichten (28, 29) aufweist, wobei der Aktorkörper (23) von einer Beschichtung (40) umgeben ist und wobei die Beschichtung (40) durch eine Sol-Gel-Transformation ausgebildet ist und die Beschichtung (40) auf der Basis metallorganischer Polymere, die durch die Sol-Gel-Transformation vernetzt sind, ausgebildet ist, wobei die Beschichtung (40) auf der Basis der in einem Lösungsmittel als Nanopartikel gelösten metallorganischen Polymere ausgebildet ist, wobei die Nanopartikel durch die Sol-Gel-Transformation dreidimensional in dem Lösungsmittel vernetzt sind, wobei die Beschichtung (40) auf einer Außenfläche (35) des Aktorkörpers (23), auf der gegebenenfalls zumindest eine außenliegende Elektrodenanbindung (36, 37) angebracht ist, als nanokristalliner, dichter, oxidkeramischer Film ausgebildet ist **dadurch gekennzeichnet, dass** bei der Herstellung der Beschichtung (40) der Werkstoff für die Beschichtung (40) auf der Außenfläche (35) des noch unbeschichteten Aktorkörpers (23), auf dem gegebenenfalls die zumindest eine außenliegende Elektrodenanbindung (36, 37) angebracht ist, abgeschieden wird.

2. Piezoelektrisches Aktormodul nach Anspruch 1, **dadurch gekennzeichnet, dass** die Nanopartikel in dem Lösungsmittel eine Größe aus einem Bereich von etwa 1 nm bis etwa 100 nm aufweisen.

3. Piezoelektrisches Aktormodul nach einem der Ansprüche 1 oder 2,
**dadurch gekennzeichnet, dass** zumindest eine außenliegende Elektrodenanbindung (36, 37) vorhanden ist, die auf der Außenfläche (35) des Aktorkörpers (23) angeordnet ist, dass die außenliegende Elektrodenanbindung (36, 37) von der Beschichtung (40), die den Aktorkörper (23) umgibt, zumindest teilweise überdeckt ist, dass die außenliegende Elektrodenanbindung (36, 37) als wärmebeständige Elektrodenanbindung (36, 37) ausgeführt ist und dass die auf den mit der außenliegenden Elektrodenanbindung (36, 37) versehenen Aktorkörper (23) aufgebrachte Beschichtung (40) einer der Sol-Gel-Transformation nachfolgenden Wärmebehandlung unterzogen ist.

4. Piezoelektrisches Aktormodul nach Anspruch 3,
**dadurch gekennzeichnet, dass** die Beschichtung (40) eine medienresistente Beschichtung (40) ist.

5. Piezoelektrisches Aktormodul nach Anspruch 4,
**dadurch gekennzeichnet, dass** die Beschichtung (40) eine druck- und brennstoffresistente Beschichtung (40) ist.

6. Brennstoffeinspritzventil (1), insbesondere Injektor für Brennstoffeinspritzanlagen von luftverdichtenden, selbstzündenden Brennkraftmaschinen, mit einem piezoelektrischen Aktormodul (19) nach einem der Ansprüche 1 bis 5 und einem von dem Aktormodul (19) betätigbaren Ventilschließkörper (12), der mit einer Ventilsitzfläche (11) zu einem Dichtsitz zusammenwirkt.

7. Brennstoffeinspritzventil nach Anspruch 6,
**dadurch gekennzeichnet,**
**dass** das piezoelektrische Aktormodul (19) in einem Aktorraum (5) angeordnet ist und dass das piezoelektrische Aktormodul (19) im Betrieb einem im Aktorraum (5) vorgesehenen unter hohem Druck stehenden Brennstoff ausgesetzt ist.

## Claims

1. Piezoelectric actuator module (19), in particular actuator module for fuel injection valves, having at least one actuator body (23), which has a multiplicity of ceramic layers (26, 27) and a multiplicity of electrode layers (28, 29) arranged between the ceramic layers (26, 27), wherein the actuator body (23) is surrounded by a coating (40) and wherein the coating (40) is formed by a solgel transformation and the coating (40) is formed on the basis of organometallic polymers crosslinked by the sol-gel transformation, wherein the coating (40) is formed on the basis of the organometallic polymers dissolved in a solvent as nanoparticles, wherein the nanoparticles are crosslinked three-dimensionally in the solvent by the sol-gel transformation, and wherein the coating (40) is formed as a nanocrystalline, dense, oxide-ceramic film on an outer surface (35) of the actuator body (23), on which at least one outer electrode connection (36, 37) is mounted if appropriate, **characterized in that**, during the production of the coating (40), the material for the coating (40) is deposited on the outer surface (35) of the still uncoated actuator body (23), on which the at least one outer electrode connection (36, 37) is mounted if appropriate.

2. Piezoelectric actuator module according to Claim 1, **characterized in that** the nanoparticles in the solvent have a size from a range of approximately 1 nm to approximately 100 nm.

3. Piezoelectric actuator module according to either of Claims 1 and 2, **characterized in that** provision is made of at least one outer electrode connection (36, 37) arranged on the outer surface (35) of the actuator body (23), **in that** the outer electrode connection (36, 37) is at least partially covered by the coating (40) which surrounds the actuator body (23), **in that** the outer electrode connection (36, 37) is in the form of a heat-resistant electrode connection (36, 37), and **in that** the coating (40) applied to the actuator body (23), which is provided with the outer electrode connection (36, 37), is subjected to a heat treatment following the sol-gel transformation.

4. Piezoelectric actuator module according to Claim 3, **characterized in that** the coating (40) is a media-resistant coating (40).

5. Piezoelectric actuator module according to Claim 4, **characterized in that** the coating (40) is a pressure-resistant and fuel-resistant coating (40).

6. Fuel injection valve (1), in particular injector for fuel injection systems of air-compressing, auto-ignition internal combustion engines, having a piezoelectric actuator module (19) according to one of Claims 1 to 5, and having a valve closing body (12) which can be actuated by the actuator module (19) and which interacts with a valve seat surface (11) to form a sealing seat.

7. Fuel injection valve according to Claim 6, **characterized in that** the piezoelectric actuator module (19) is arranged in an actuator chamber (5), and **in that** during operation the piezoelectric actuator module (19) is exposed to a fuel at high pressure provided in the actuator chamber (5).

## Revendications

1. Module d'actionneur piézoélectrique (19), en particulier module d'actionneur pour des soupapes d'injection de carburant, comprenant au moins un corps d'actionneur (23) qui présente une pluralité de couches céramiques (26, 27) et une pluralité de couches d'électrodes (28, 29) disposées entre les couches céramiques (26, 27), le corps d'actionneur (23) étant entouré d'un revêtement (40) et le revêtement (40) étant réalisé par une transformation sol-gel et le revêtement (40) étant réalisé à base de polymères métallo-organiques qui sont réticulés par la transformation sol-gel, le revêtement (40) étant réalisé à base des polymères métallo-organiques dissous dans un solvant sous forme de nanoparticules, les nanoparticules étant réticulées par la transformation sol-gel de manière tridimensionnelle dans le solvant, le revêtement (40) étant réalisé sur une surface extérieure (35) du corps d'actionneur (23) sur laquelle est éventuellement appliquée au moins une liaison d'électrode située à l'extérieur (36, 37), en tant que film nanocristallin, dense, en oxyde céramique, **caractérisé en ce que** lors de la fabrication du revêtement (40), le matériau pour le revêtement (40) est déposé sur la surface extérieure (35) du corps d'actionneur (23) encore non revêtu, sur lequel est éventuellement appliquée l'au moins une liaison d'électrode située à l'extérieur (36, 37).

2. Module d'actionneur piézoélectrique selon la revendication 1, **caractérisé en ce que** les nanoparticules dans le solvant présentent une taille comprise dans une plage d'environ 1 nm à environ 100 nm.

3. Module d'actionneur piézoélectrique selon l'une quelconque des revendications 1 ou 2, **caractérisé en ce qu'**au moins une liaison d'électrode située à l'extérieur (36, 37) est prévue, laquelle est disposée sur la surface extérieure (35) du corps d'actionneur (23), **en ce que** la liaison d'électrode située à l'extérieur (36, 37) est recouverte au moins partiellement par le revêtement (40) qui entoure le corps d'actionneur (23), **en ce que** la liaison d'électrode située à l'extérieur (36, 37) est réalisée sous forme de liaison d'électrode résistant à la chaleur (36, 37) et **en ce que** le revêtement (40) appliqué sur le corps d'actionneur (23) pourvu de la liaison d'électrode située à l'extérieur (36, 37) est soumis à un traitement thermique après la transformation sol-gel.

4. Module d'actionneur piézoélectrique selon la revendication 3, **caractérisé en ce que** le revêtement (40) est un revêtement (40) résistant aux milieux.

5. Module d'actionneur piézoélectrique selon la revendication 4, **caractérisé en ce que** le revêtement (40) est un revêtement (40) résistant à la pression et au carburant.

6. Soupape d'injection de carburant (1), en particulier injecteur pour des installations d'injection de carburant de moteurs à combustion interne à compression d'air et auto-allumage, comprenant un module d'actionneur piézoélectrique (19) selon l'une quelconque des revendications 1 à 5, et un corps de fermeture de soupape (12) pouvant être actionné par le module d'actionneur (19), lequel coopère avec une surface de siège de soupape (11) pour former un ajustement étanche.

7. Soupape d'injection de carburant selon la revendication 6, **caractérisée en ce que** le module d'actionneur piézoélectrique (19) est disposé dans un espace d'actionneur (5) et **en ce que** le module d'actionneur piézoélectrique (19), pendant le fonctionnement, est soumis à un carburant à haute pression prévu dans l'espace d'actionneur (5).
